# EUROPEAN PATENT SPECIFICATION

(11) **EP 1 159 774 B1**
(45) Date of publication and mention of the grant of the patent: **04.08.2004**
(21) Application number: 00912081.7
(22) Date of filing: 29.02.2000
(51) Int. Cl.: H01S 5/026, H01S 5/06

(54) **A TUNABLE LASER SOURCE WITH AN INTEGRATED WAVELENGTH MONITOR AND METHOD OF OPERATING SAME**
ABSTIMMBARER LASER MIT EINER INTEGRIERTEN VORRICHTUNG ZUR WELLENLÄNGENÜBERWACHUNG UND ZUGEHÖRIGES BETRIEBSVERFAHREN
SOURCE LASER ACCORDABLE A SURVEILLANCE INTEGREE DE LA LONGUEUR D'ONDE, ET MODE DE MISE EN OEUVRE

(30) Priority: 01.03.1999 US 122194 P
(43) Date of publication of application: 05.12.2001
(73) Proprietor: The Regents of the University of California, Oakland, CA 94607-5200 (US)
(72) Inventor: COLDREN, Larry, Santa Barbara, CA 93110 (US); MASON, Thomas, Gordon, B., Middletown, NJ 07748 (US); FISH, Gregory, Santa Barbara, CA 93110 (US)
(74) Representative: Altenburg, Udo, Dipl.-Phys.
(86) International application number: PCT/US2000/005235
(87) International publication number: WO 2000/052789

(56) References cited:
- EP-A- 0 615 321
- EP-A- 0 818 859
- EP-A- 0 867 989
- EP-A- 0 939 470
- WO-A-97/05679
- WO-A-99/43060
- US-A- 4 309 671
- US-A- 5 323 409
- MASON B ET AL: "TUNABLE SAMPLED-GRATING DBR LASERS WITH INTEGRATED WAVELENGTH MONITORS" IEEE PHOTONICS TECHNOLOGY LETTERS,US,IEEE INC. NEW YORK, vol. 10, no. 8, 1 August 1998 (1998-08-01), pages 1085-1087, XP000769864 ISSN: 1041-1135
- PATENT ABSTRACTS OF JAPAN vol. 1996, no. 03, 29 March 1996 (1996-03-29) -& JP 07 307516 A (KOKUSAI DENSHIN DENWA CO LTD), 21 November 1995 (1995-11-21)

## Description

### Related Applications

The present application is related to U. S. Provisional Patent Application, serial no. 60/122,194, filed on March 1,1999.

### Background of the Invention

### 1. Field of the Invention

The invention relates to the field of semiconductor lasers, and in particular to tunable semiconductor lasers.

### 2. Description of the Prior art

There are a variety of semiconductor laser designs in which the wavelength can be tuned by current injection into a section which has some spectral filtering characteristic. Examples of these are moderately tunable devices such as the distributed Bragg reflector laser, which consists of a gain section, a phase control section and a grating mirror, and widely tunable lasers that employ Vernier effect tuning like the sampled grating distributed Bragg reflector lasers. In all of these devices precise control of the tuning current is required to achieve the desired output wavelength. The amount of current required to achieve a given wavelength can vary with the device temperature and also with aging. Over time as the laser ages changes in the leakage current and the carrier lifetime in the tuning sections cause the wavelength to drift. This variation in the tuning characteristics requires the use of some sort of feedback control system in order for such tunable lasers to be used in applications where precise wavelength control must be maintained such as dense wavelength division multiplexed (WDM) communications systems.

Single wavelength devices such as distributed feedback lasers are also subject to wavelength drift. For these devices simple wavelength lockers are used with temperature or current feedback to control the wavelength of the laser.

However these wavelength lockers are only capable of maintaining the laser wavelength on a single channel which makes them useless as multiple-channel tunable lasers.

Tunable semiconductor lasers are important components for next generation dense wavelength division multiplexed fiber optic networks.

Mason et al. have described in IEEE Photonics Technology Letters, 1998, pages 1085-1087 and in Conf. Digest of the Semiconductor Laser Conference, 1998, pages 267-268, a laser monolithically fabricated on a common stucture, wherein light samples from said laser is directed through a two-mode interference (TMI) waveguide. With this TMI waveguide, two waveguide-originated, wavelength-dependent optical signals are generated which are transformed into electrical signals by two detectors.

What is needed is a frequency stable, tunable laser module whose output frequency does not change over time. The device should be integrated on a chip, compact and cost effective. It should have a wide tuning range and be usable in high speed data transmission under direct modulation in multichannel dense WDM networks.

### Brief Summary of the Invention

These and other objects are achieved according to the invention by a monolithic semiconductor integrated optical apparatus for generating specific wavelengths within a wide optical bandwidth as defined in independent claim 1. Advantageous embodiments are depicted in the dependent claims. Advantages of the present invention will be apparent to those skilled in the art.

What has been developed is a wavelength monitor based on the transmission response of an optical filter for use in controlling the wavelength of a tunable laser. This monitor can provide feedback on the laser's wavelength over a wide tuning range enabling it to also lock the device to any given wavelength or channel within its tuning range. It can also be used in combination with conventional external lockers to more precisely tune to a particular wavelength within a given channel.

The invention is also a process for integrating the wavelength monitor directly on chip with a variety of tunable semiconductor lasers. This results in a significantly more compact and cost effective device.

The invention comprises a method for controlling the wavelength of a tunable laser by using a wavelength monitor to measure the output light and provide feedback to a control system. In the preferred embodiment the laser and wavelength monitor are integrated together on a single indium phosphide chip.

The technique is useful for control of lasers that are tuned by current injection into sections which have a bandgap energy, which is greater than the lasing wavelength.

The wavelength monitor comprises a wavelength filtering element and a pair of detector elements. In one embodiment these elements are combined by using detectors of different bandgap arrange in series. In others a separate filter with a wavelength dependent transmission function is placed in front of the detectors. In some of these embodiments this separate filter is designed as a wavelength dependent splitter to provide an output beam that translates laterally from one detector to the other as a function of wavelength (much like a prism); in other embodiments the laser output is first split into two beams, and a wavelength dependent transmission filter is placed only in one of these prior to illuminating the detectors. In all cases, taking the difference between in the photocurrents in the two detectors, and normalizing by dividing by the sum, provides a measure of the integrated laser's wavelength. In all cases, the net filtering function is designed such that the normalized difference current is monotonic and varies from a minimum at one extent of the laser's tuning range to a maximum at the other extent. This approach can provide channel identification across this entire band of wavelengths, and it can supplement or replace the function of existing external wavelength lockers that only lock within the span of one channel.

The invention having been summarized can be better visualized by turning to the following drawings wherein like elements are referenced by like numerals.

### Brief Description of the Drawings

Fig. 1 is a perspective schematic of a tunable laser fabricated according to the prior art.
Fig. 2 is a graph of wavefunction intensity showing the overlap of two mode interference waveguide modes with a laser mode in a TMI waveguide section as a function of lateral dimension.
Fig. 3 a is a side cross-sectional view of an active section of the laser.
Fig. 3b is a side cross-sectional view of a passive section of the laser.
Fig. 4 is a perspective schematic of an example of a tunable laser fabricated according to the prior art in which a buried heterostructure is provided.
Fig. 5 is a graph of the normalized detector response as a function of wavelength for the example of Fig. 4 showing sinusoidal wavelength dependence.
Fig. 6 is a graph of fiber launched power and detector current as a function of drive current for the example of Fig. 4 with fixed tuning currents.
Fig. 7a is a schematic of an embodiment of a tunable laser including series connected detectors according to the present invention.
Fig. 7b is a graph of the photocurrents from two detectors shown as a functionof wavelength according to the present invention.
Fig. 8 is a schematic diagram of an example of a tunable laser in which the wavelength monitor is implemented with external or nonintegrated components.
Fig. 9 is a top plan schematic view of still another embodiment of the present invention using an external wavelength monitor implementation of a dielectric filter in a planar lightwave circuit platform.
Fig. 10 is a schematic diagram of an embodiment of the present invention in which reflection from a wavelength dependant dielectric film is used to implement the wavelength monitor.
Fig. 11 is a schematic diagram of an embodiment of the present invention in which reflection from the wavelength dependant dielectric film is used to implement the wavelength monitor as in the case of Fig. 10, but without the use of a beam splitter.

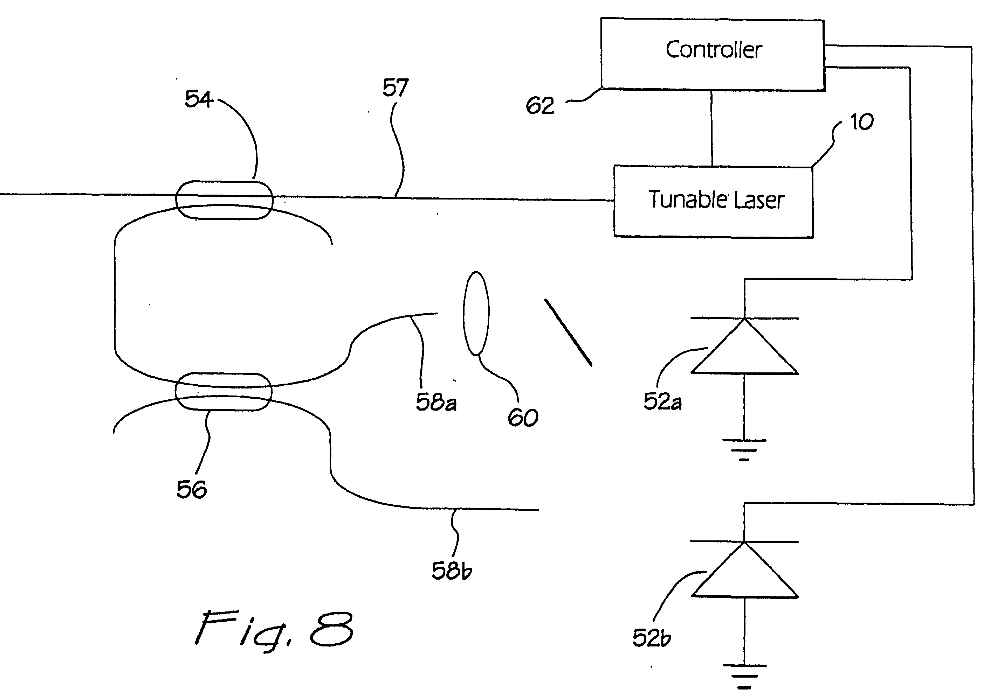

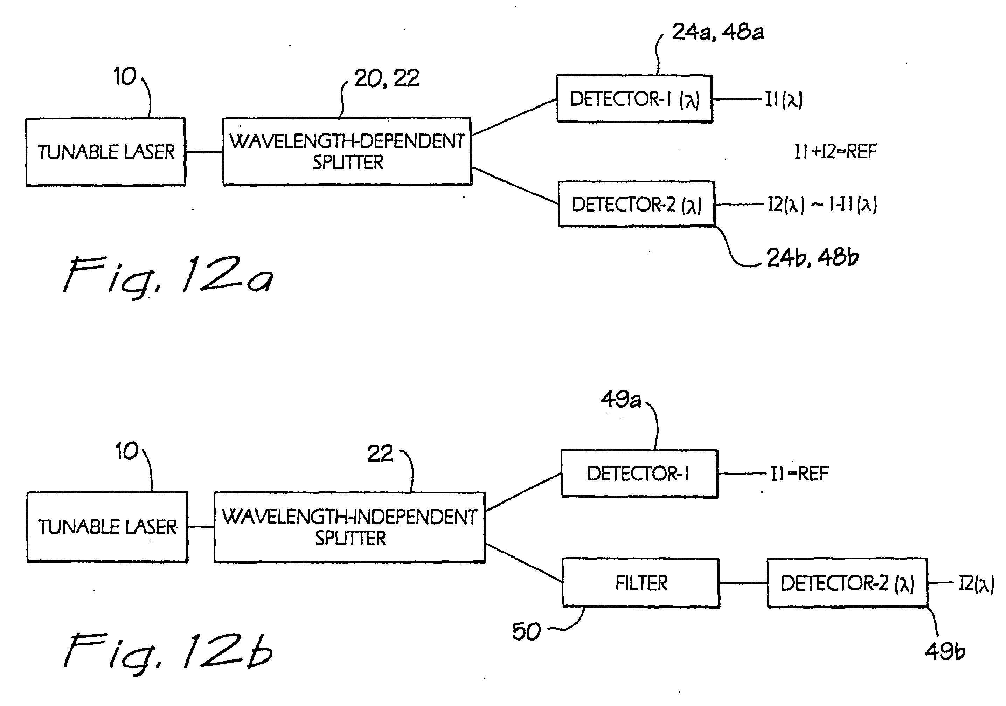

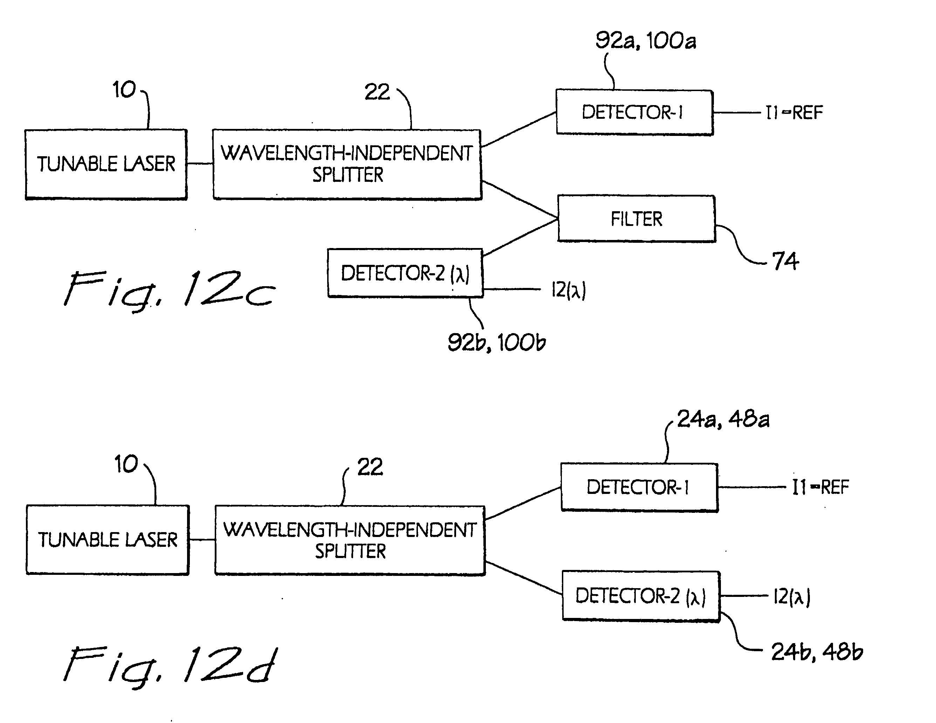

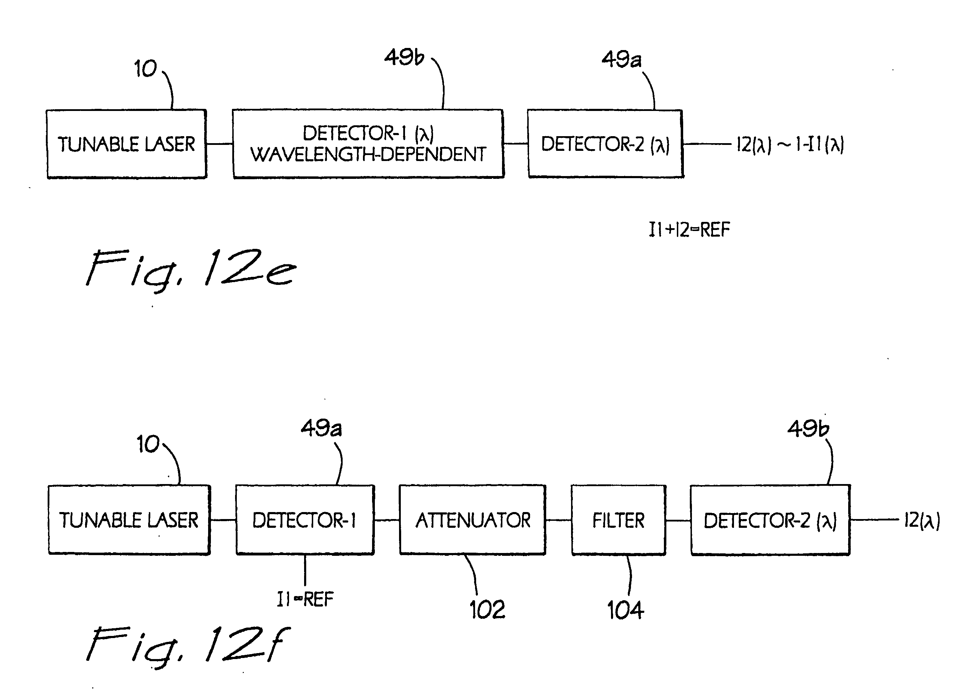

Figs. 12a to 12f are schematic drawings of the embodiments or examples shown in Figs. 1, 4, 7, 8, 10 and 11, respectively.

The invention and its various embodiments can be better understood by turning to the following detailed description of the illustrated embodiments. It is to be expressly understood that the invention as defined in the following claims is not to be limited by the illustrated embodiments.

### Detailed Description of the Preferred Embodiments

Tunable semiconductor lasers are important components for next generation dense wavelength division multiplexed fiber optic networks. The wide tuning range, and ability for high speed data transmission under either direct or external modulation, of sampled grating, distributed Bragg reflector (SGDBR) lasers makes them especially attractive for use in multichannel dense WDM networks. These lasers tune over wide wavelength ranges by employing Vernier effect tuning. Wavelength control in these devices requires the alignment of reflection peaks from the front and back mirrors with the cavity mode at the desired wavelength. This entails control of four separate tuning currents to achieve complete wavelength coverage over the entire tuning range. Using feedback on the output wavelength and intensity, it is possible to lock the device at the optimum operating point for a given wavelength.

Existing devices for monitoring the wavelength and output power of a tunable laser are too complicated and expensive for practical application. What has been devised is a compact integrated wavelength monitor that can be fabricated on chip with a tunable laser to provide feedback on the wavelength and output power. In an example there is an external version of the same monitor which is low cost and highly stable.

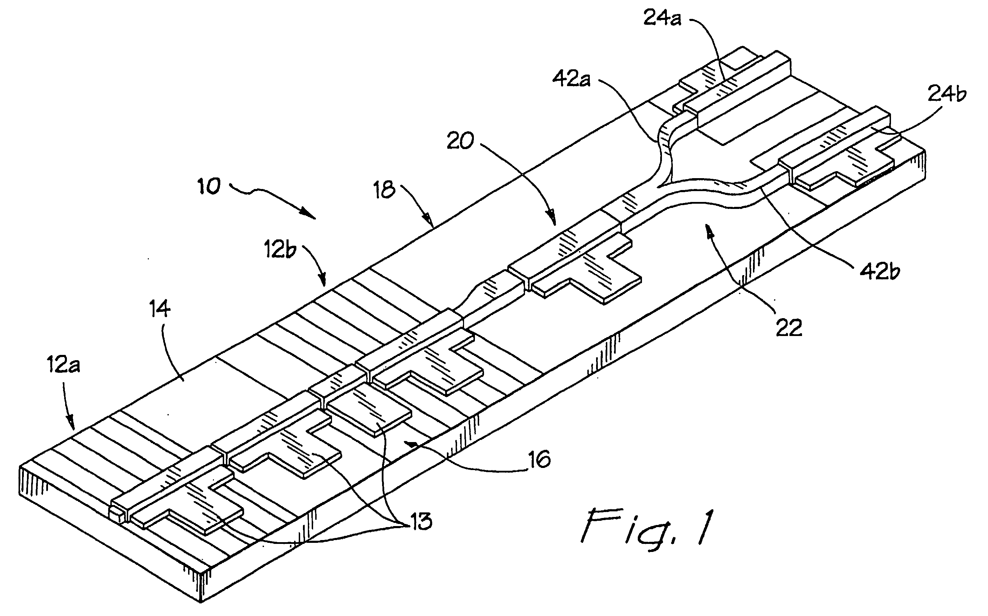

In the example the apparatus of the invention is comprised of a SGDBR laser coupled to a wavelength dependent splitter and a pair of integrated detectors. A schematic of the device is shown in Fig. 1. The laser, generally denoted by reference numeral 10, is a 3µm wide ridge waveguide device which is comprised of four separate elements. These include two sampled grating DBR mirrors 12a and 12 b and sections for gain control 14 and phase control 16. By controlling the injection current into gain control 14 and phase control 16, laser 10 can be made to tune over more than 40 nm with continuous wavelength coverage. At the output 18 of the back mirror section 12b, the laser waveguide is asymmetrically coupled into a two mode interference (TMI) waveguide 20. At the end of the TMI section 20, there is a Y-branch splitter 22 that divides the light into a pair of output detectors 24a and 24b. This ratiometric design results in a compact easily fabricated wavelength monitor. generally denoted by reference numeral 26.

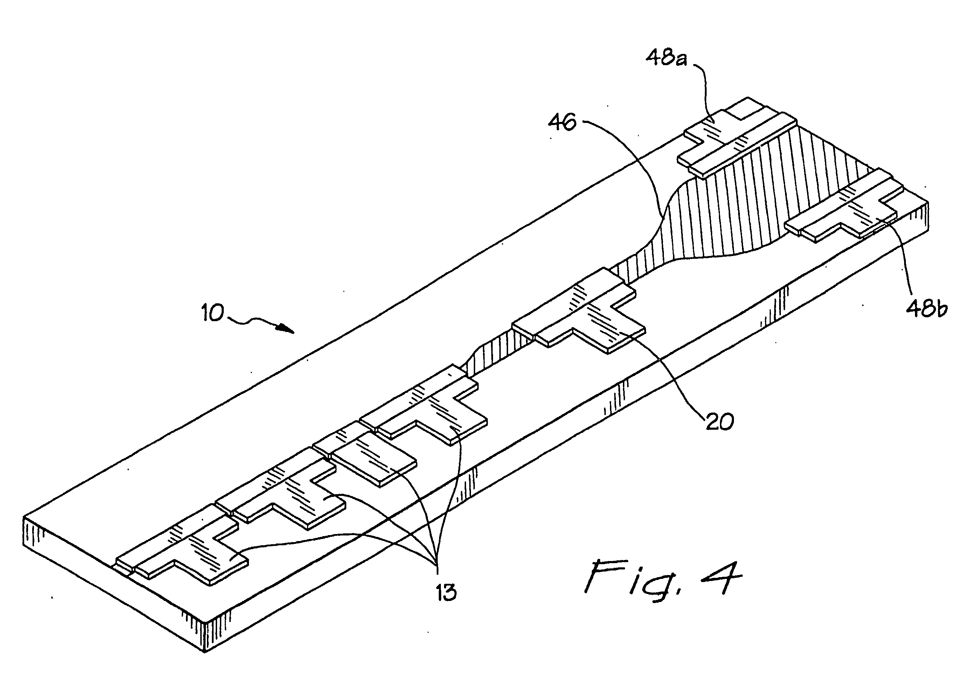

The generalized transverse active device structure as shown in side cross-sectional view of Figs. 3a is comprised of a thick higher bandgap energy waveguide layer 28 with an offset multiquantum well active region 30. Waveguide 30, which in the illustrated embodiment is a 400 nm, 1.4Q waveguide, is disposed on a 300 nm n-type buffer layer 32. The thick high bandgap waveguide layer 28 is necessary for good carrier-induced index change in the tuning sections, which are comprised of sampled grating DBR mirrors 12a and 12 b and sections for gain control 14 and phase control 16. In the case of the active section of Fig. 3a, an InP etch stop layer 34 is disposed on waveguide layer 28 on which strained quantum well active layer 30 is in turn disposed. In the case of a passive section, layers 34 and 30 are omitted. Nonabsorbing passive elements as shown in the side cross-sectional view of Fig. 3b are formed by selectively removing the quantum wells from on top of the waveguide 28. A p-type InP ridge 36 is then disposed on quantum well layer 30 in the case of an active section as shown in Fig. 3a or on waveguide 28 in the case of a passive section as shown in Fig. 3b. A 100 nm InGaAs contact layer 38 is then disposed on top of ridge 36. The use of the offset quantum wells 30 allows the formation of active and passive sections in a single waveguide without having to perform a butt joint regrowth. This allows the device to be fabricated with only two chemical vapor deposition (MOCVD) growth steps.

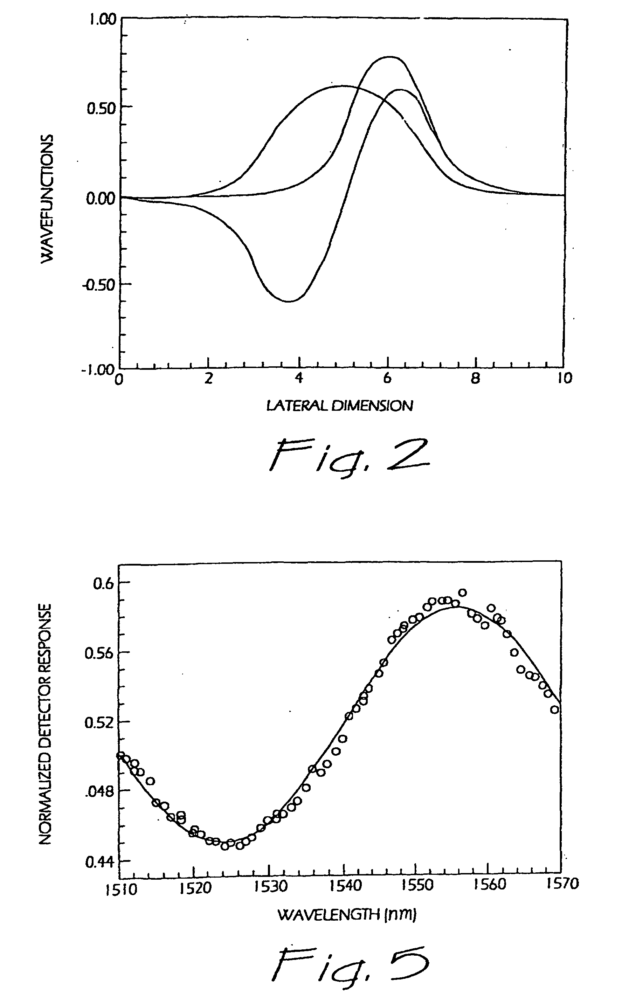

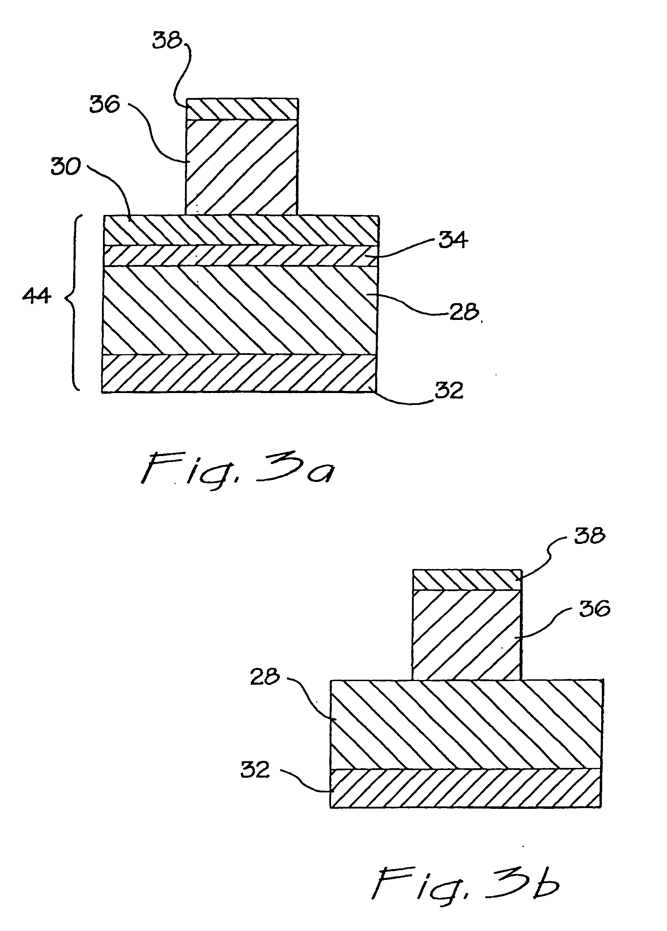

Light coupled from the laser 10 into the TMI section 20 excites the two lowest order lateral modes of the waveguide as shown in the graph of Fig 2. These modes propagate with different phase velocities which leads to a characteristic beating in a modal superposition pattern. The beat length is dependent on the difference in the propagation constants for the two modes which each depend on the wavelength of the light. At the end of the TMI section 20, a Y-branch splitter 40 splits the light into a pair of output waveguides 42a and 42b with a wavelength dependent splitting ratio. By making the TMI section 20 long enough to contain several beat lengths, the splitting ratio becomes increasingly sensitive to the wavelength of the laser 10. The total power out of the back facet 18 of the laser 10 can be determined by summing the currents from both detectors 24a and 24b. The wavelength dependent signal is normalized to this sum to remove the power dependence. This results in a sinusoidal output signal that varies with wavelength. The TMI waveguide 20 is wide at its ends to enhance the optical coupling and tapers quadraticly along its central interference section to increase the modal dispersion. The splitter 40 employs a Y-branch design to divide the incoming optical power into two output waveguides 42a and 42b. The output waveguides 42a and 42b contain the photodetectors 24a and 24b respectively which measure the divided light intensity. Large detector sizes are used to prevent saturation of their absorption by the high optical power levels that are experienced in the photonic integrated circuit.

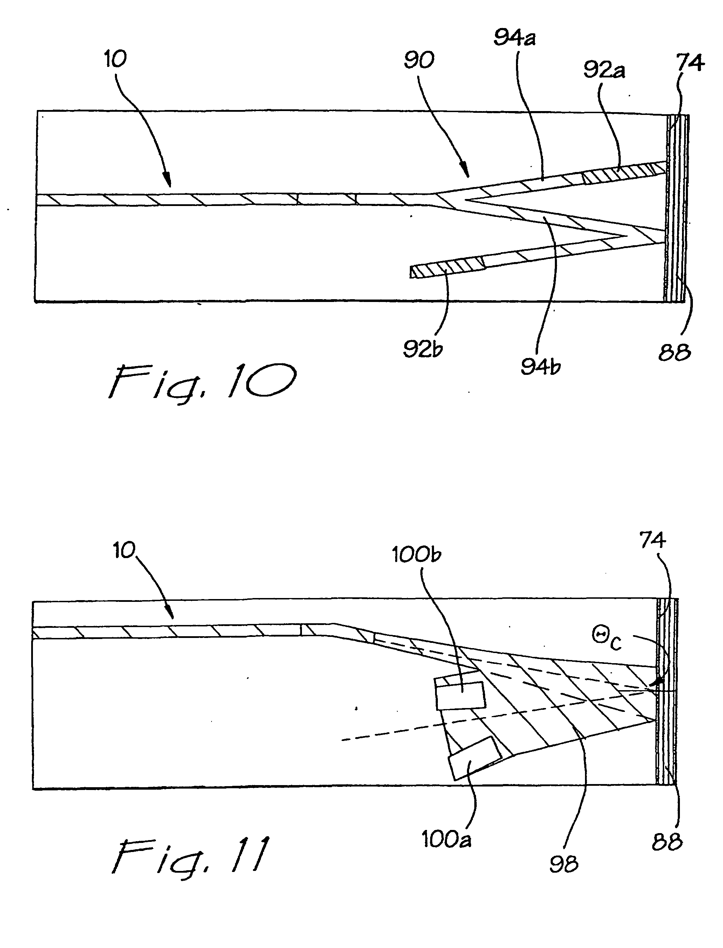

The detector signals can then be coupled to a conventional processor or controller circuit (not shown) where the control signal is generated from the ratio of the detection signals, normalized if needed, and coupled to laser 10 to provide the appropriate tuning control. The manner in which the data or signals are processed according to the teachings of the invention is conventional and therefore will not be further illustrated in detail. It is contemplated that the processor or controller circuit will be integrated or assembled into the chip or may be externally provided as shown in Fig. 8 below.

A key advantage of the TMI wavelength monitor 26 is that it can be fabricated using many of the steps required for tunable lasers 10, making it relatively easy to integrate on chip. There are eight main steps in the fabrication procedure for the SGDBR laser with the integrated wavelength monitor. First, a base structure 44 is grown using near atmospheric MOCVD with tertiarybutlyphosphine and tertiarybutylarsine for the group V sources. The transverse structure for the active and passive sections are shown in Figs. 3a and 3b respectively. Passive sections are formed by selectively etching off the cap layer (not shown) and then the quantum wells 30. The gratings 12a and 12b are then formed for the laser mirrors using a dry etch process.

In the second MOCVD step, a 2 µm InP upper cladding layer 36 and a 100nm InGaAs contact layer 38 are regrown. The ridge waveguides are etched to within 200nm of the waveguide layer using a methane-hydrogen-argon (MHA RIE) etch. A wet etch (HCL:H₃PO₄) is then used to remove the last 200nm and stop on the waveguide 28. The dry etch is done to maintain the straight side walls in the curved waveguide section, while the final wet etch compensates for the nonuniformity in the MHA RIE and provides for consistent etch depth. A SiNₓ layer (not shown) is used to passivate the surface with self-aligned openings on the ridge tops for the Ti/Au p-contacts 13. Isolation between the adjacent laser sections and between the detectors is achieved by etching off the contact layer 38 and performing a deep proton implant(not shown). This step is essential for providing good isolation between the reversed biased detectors 24a and 24b and the forward biased laser sections 10. In the final steps, the device is lapped to 100 µm thick, and a backside contact (not shown) is deposited before cleaving and mounting.

It is also possible to fabricate this device with a buried heterostructure. In this case the Y-branch splitter and detector pair of Fig. 1 can still be used, but in Fig. 4 a tapered waveguide 46 with two detectors 48a and 48b placed on each side are used in place of the Y-branch splitter 40. The output mode from the TMI waveguide 20 is then imaged on the region between the detectors 48a and 48b to provide a position sensitive output difference count. The fabrication is similar to the ridge process except that the ridge is etched prior to regrowth and the etch proceeds until it has cut completely through the waveguide 28. Then in the regrowth InP material is grown up around the ridge completely burying it. The contact layer 38 is then patterned so that it only covers the area directly over the buried ridge 36 and a proton implantation step is also used to prevent lateral current spreading.

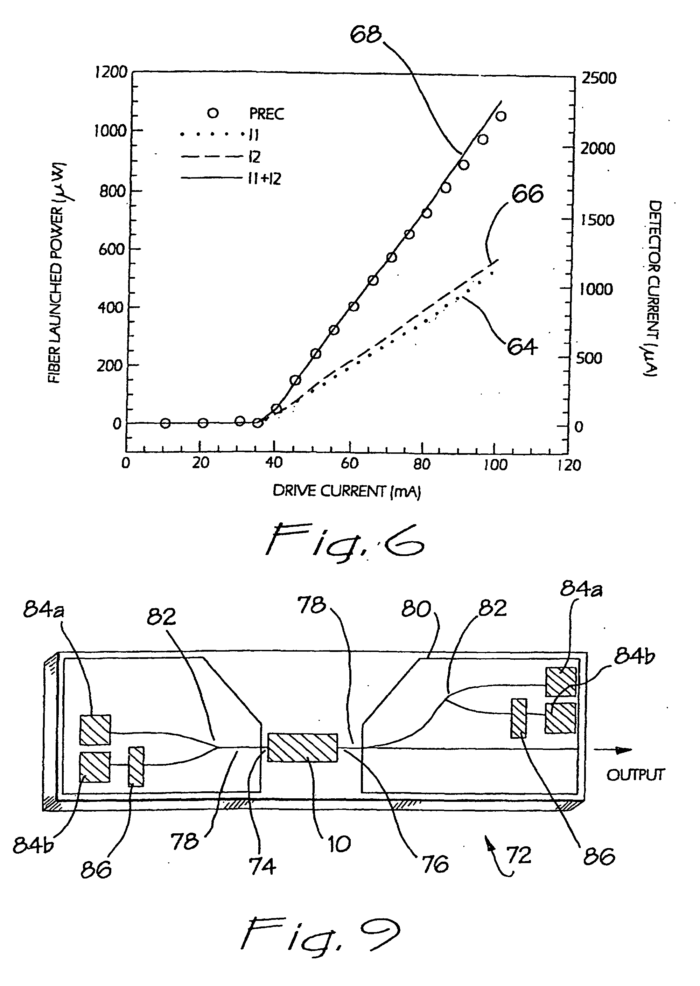

When the wavelength of the laser 10 is tuned, the two detectors 48a and 48b provide complementary sinusoidal responses for wavelength monitoring. Taking the ratio of the difference between the detector currents to the sum of the detector currents provides a single monotonically varying signal which is wavelength dependent and power level independent as shown in the graph of Fig. 5. The sum of the two detector currents can be used to monitor the laser output power as shown in the graph of Fig. 6. The current from detector 48a is shown by line 64, the current from detector 48b is shown by line 66, and their sum is shown by line 68. Dots 70 show the measured launched power in the output fiber. It is important for both this and the operation of the wavelength monitor 26 that the photodiode response is as close to linear as possible and that both detectors 48a and 48b are well matched. Again the detection signals are processed by a signal processor or controller (not shown) according to conventional means consistent with the teachings of the invention.

An example for the wavelength monitor 26 would employ a pair of detectors 24a and 24b similar to those shown in either Figs. 1 or 4 in which the bandgap of the absorbing section of the two detectors was different. One detector 24a would have a bandgap which was low enough to provide full absorption of the incident light so that it's detection current would be proportional only to the photon density. The other detector 24b would have a higher bandgap such that the absorption would vary with the wavelength of the light. This would be accomplished by using a short detector length with a band gap energy slightly greater than the shortest wavelength of light. The detection response would then vary monotonically with wavelength. Again the detection signals are processed by a signal processor or controller (not shown) according to conventional means consistent with the teachings of the invention.

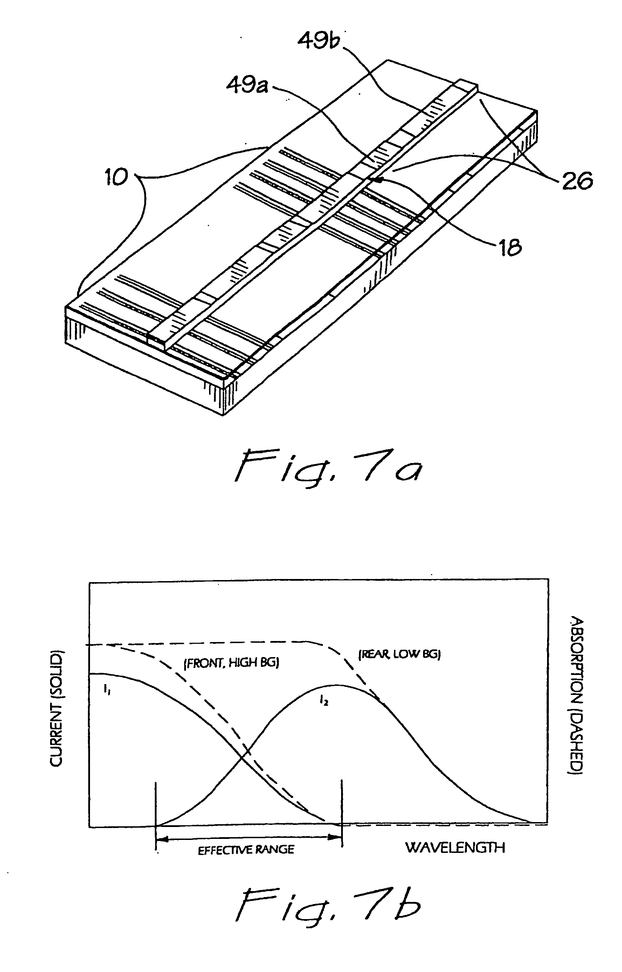

A potential embodiment for the wavelength monitor 26 would employ a pair of detectors 49a and 49b with different bandgaps placed in series along a single passive waveguide continuing from the output 18 of laser 10 as illustrated in Fig. 7a. As can be seen, this embodiment eliminates the need for the Y-branch splitter as well as the dispersive TMI dispersive waveguide section. The back detector 49b is highly absorbing across the entire band while the front detector 49a has an absorption edge beginning near the shorter wavelength side of the tuning range as illustrated in Fig. 7b. This front detector 49a is relatively short, so that it only partially absorbs the incident light, thus transmitting about half of it in the center of the laser's tuning range. Thus, the net photocurrent would appear as in Fig. 7b for the two detectors. Therefore, as in other cases an unambiguous wavelength readout can be obtained by using the ratio of the difference to the sum of the two currents. An advantage of this embodiment is that it is much shorter than ones requiring the TMI and Y-branch sections.

It is also possible to implement the wavelength monitor 26 using an external device as shown in the schematic diagram of Fig. 8. In this example a dielectric filter 50 is used with a wavelength dependent response and a pair of detectors 52a and 52b. A 10/90 fiber optic splitter 54 is used to tap some of the output light from the laser 10 on optic fiber 57 which is split using a 3 dB coupler 56 into two separate optic fibers 58a and 58b. One fiber 58b is coupled directly to a reference detector 52b. Detector 52b monitors the laser power. The other fiber 58a has a collimator 60 with the filter element 50 in front of it. This gives it a wavelength dependent response. The signal from detector 52a is divided in a controller circuit 62 coupled to laser 10 by the signal from the reference detector 52b to provide a power independent signal.

The external device illustrated in Fig. 8 can also be implemented in a very compact manner using a hybrid technology shown in Fig. 9. The laser is mounted accurately onto a planar lightwave circuit (PLC) platform 72 such that the power emitted by either the back 74 or front 76 facet is coupled into the PLC waveguide 78. If the front facet 76 used, the light from the laser 10 is passed first through a wavelength independent 5/95 tap 80 such that the majority of the light can be used as output. Light from back facet 78 is transmitted entirely to monitor 26 without tapping. The monitored or tapped portion of light is then passed though a wavelength independent 3 dB splitter 82 which couples the pair of photodetectors 84a and 84b also bonded to the PLC platform 72. Before detector 84b is a wavelength filtering element 86 is inserted. This can be implemented by a either a waveguide coupler filter or the waveguide can be cut through and the filter described in Fig. 8 is placed in the groove with an index matched epoxy. Again the detection signals are processed by a signal processor or controller (not shown) according to conventional means consistent with the teachings of the invention.

Another embodiment for the wavelength monitor 26 is diagrammatically shown in Fig. 10. This embodiment employs a filter coating 88 deposited on the back facet 74 of the laser 10. A Y-splitter 90 is used to divide the light into two paths. One path 94a is incident on a reference detector 92a for measuring the light intensity and the other path 94b reflects off of the back facet 74 at an angle of incidence less than the critical angle. Thin film facet coating 88 with a wavelength dependent reflectivity is used. The intensity of the reflected light varies with the wavelength providing a signal which is used for wavelength monitoring in detector 92b. Again the detection signals are processed by a signal processor or controller (not shown) according to conventional means consistent with the teachings of the invention.

This method is also used in the embodiment schematically shown in Fig. 11 without a Y-splitter 90 by letting the light diffract so that a portion of the light is incident on the facet 74 at an angle greater than the critical angle, θ_{c}, and a portion is incident at an angle less than the critical angle, θ_{c}. The laser output may be curved somewhat to facilitate separation of these two portions and to prevent feedback into the laser section. Light from back facet 74 is reflected by wavelength dependent facet coating 88 at an angle to facet 74. The portion of light which was subject to total internal reflection 98 is collected by a reference detector 100a and the portion which is subject to a wavelength dependent reflection is collected by a second detector 100b. The function of facet coating 88 might also be accomplished by an integrated grating similar to those formed in the tunable laser.

Many alterations and modifications may be made by those having ordinary skill in the art without departing from the scope of the invention. Therefore, it must be understood that the illustrated embodiment has been set forth only for the purposes of example and that it should not be taken as limiting the invention as defined by the following claims. For example, notwithstanding the fact that the elements of a claim are set forth below in a certain combination, it must be expressly understood that the invention includes other combinations of fewer, more or different elements, which are disclosed in above even when not initially claimed in such combinations.

The words used in this specification to describe the invention and its various embodiments are to be understood not only in the sense of their commonly defined meanings, but to include by special definition in this specification structure, material or acts beyond the scope of the commonly defined meanings. Thus if an element can be understood in the context of this specification as including more than one meaning, then its use in a claim must be understood as being generic to all possible meanings supported by the specification and by the word itself.

The definitions of the words or elements of the following claims are, therefore, defined in this specification to include not only the combination of elements which are literally set forth, but all equivalent structure, material or acts for performing substantially the same function in substantially the same way to obtain substantially the same result. In this sense it is therefore contemplated that an equivalent substitution of two or more elements may be made for any one of the elements in the claims below or that a single element may be substituted for two or more elements in a claim.

Insubstantial changes from the claimed subject matter as viewed by a person with ordinary skill in the art, now known or later devised, are expressly contemplated as being equivalently within the scope of the claims. Therefore, obvious substitutions now or later known to one with ordinary skill in the art are defined to be within the scope of the defined elements.

The claims are thus to be understood to include what is specifically illustrated and described above, what is conceptionally equivalent, what can be obviously substituted and also what essentially incorporates the essential idea of the invention.

## Claims

1. A monolithic semiconductor integrated optical apparatus for generating specific wavelengths within a wide optical bandwidth comprising:
a widely tunable semiconductor laser (10);
a wavelength-dependent optical device to produce two optical signals from light sampled from said laser (10), which two optical signals are wavelength dependent and distinguished from each other by a different dependence on wavelength;
a first and second detector (49a, 49b; 92a, 92b; 100a, 100b) to detect said two optical signals to generate two corresponding electrical detection signals (I1(λ), I2(λ)); and
a processor being coupled to said first and second detector (49a, 49b; 92a, 92b; 100a, 100b) to generate a control signal from said two corresponding electrical detection signals by which said tunable laser is tuned;
wherein the monolithic semiconductor integrated apparatus is integrated on a single monolithic semiconductor chip such that the tunable semiconductor laser (10), the wavelength-dependent optical device and the first and second detector (49a, 49b; 92a, 92b; 100a, 100b) are monolithically integrated and monolithically fabricated together from a common materials structure and fabrication process, and such that the wavelength-dependent optical device generates the two optical signals as two nonwaveguide-originated, wavelength-dependent optical signals by means of:
a. a wavelength independent splitter (22) to divide the light sampled from the laser (10) between the two detectors (49a, 49b), one of which is provided with a wavelength dependent integrated transmission filter (50) fabricated from the common materials structure and fabrication process; or
b. a wavelength independent splitter (22) to divide the light sampled from the laser (10) between the two detectors (92a, 92b; 100a, 100b), one of which is combined with a wavelength dependent integrated reflective filter (74) fabricated from the common materials structure and fabrication process; or
c. the two detectors (49a, 49b) are in line with each other and the laser (10) and one of the detectors (49b) is wavelength dependent by reason of a higher bandgap absorption in the detector and is preferably preceded by an attenuator (102) and filter (104).

## Patentansprüche

1. Ein optisches Gerät mit integriertem monolithischen Halbleiter zum Erzeugen spezieller Wellenlängen innerhalb einer breiten optischen Bandbreite, umfassend:
einen breit abstimmbaren Halbleiterlaser (10);
eine Wellenlängen-abhängige optische Vorrichtung, um zwei optische Signale, um Licht zu erzeugen, das von dem Laser (10) entnommen wurde, wobei die zwei optischen Signale Wellenlängen-abhängig sind und sich von einander durch eine verschiedene Abhängigkeit von der Wellenlänge unterscheiden;
einen ersten und einen zweiten Detektor (49a, 49b; 92a, 92b; 100a, 100b), um die zwei optischen Signale zu erfassen, um zwei entsprechende elektrische Erfassungssignale (I1(λ), I2(λ)); und
einen Prozessor, der mit dem ersten und zweiten Detektor (49a, 49b; 92a, 92b; 100a, 100b) gekoppelt ist, um ein Steuerungssignal von den zwei entsprechenden Erfassungssignalen zu erzeugen, durch welches der abstimmbare Laser abgestimmt wird;
wobei das Gerät mit integriertem monolithischen Halbleiter auf einem einzigen monolithischen Halbleiterchip integriert ist, so dass der abstimmbare Halbleiterlaser (10), die Wellenlängen-abhängige optische Vorrichtung und der erste und zweite Detektor (49a, 49b; 92a, 92b; 100a, 100b) monolithisch integriert und von einer gemeinsamen Materialienstruktur und durch ein Herstellungsverfahren monolithisch hergestellt sind, und so dass die Wellenlängen-abhängige optische Vorrichtung zwei optische Signale als zwei Wellenlängen-abhängige optische Signale generiert, die nicht durch einen Lichtwellenleiter erzeugt wurden, mittels:
a. eines Lichtwellen-unabhängigen Splitters (22), um das Licht, das von dem Laser (10) entnommen wurde, zwischen den zwei Detektoren (49a, 49b) aufzuteilen, von denen einer mit einem Wellenlängen-abhängigen, integrierten Übertragungsfilter (50) versehen ist, der auf der gemeinsamen Materialienstruktur und durch das Herstellungsverfahren hergestellt wurde; oder
b. eines Wellenlängen-unabhängigen Splitters (22), um das Licht, das von dem Laser (10) entnommen wurde, zwischen den zwei Detektoren (92a, 92b, 100a, 100b) aufzuteilen, von denen einer mit einem Wellenlängen-abhängigen, integrierten Reflektionsfilter (74) kombiniert ist, der aus der gemeinsamen Materialienstruktur und durch das Herstellungsverfahren hergestellt wurde; oder
c. zwei Detektoren (49a, 49b), die in Reihe zueinander und in Bezug auf den Laser (10) angeordnet sind, und wobei einer der Detektoren (49b) Wellenlängen-abhängig ist auf Grund einer höheren Bandlücken-Absorption in dem Detektor, dem vorzugsweise ein Abschwächer (102) und ein Filter (104) vorausgeht.

## Revendications

1. Dispositif optique intégré magnétique à semiconducteurs pour produire des longueurs d'onde spécifiques dans une largeur de bande optique étendue, comprenant:
un laser à semiconducteurs (10) pouvant être accordé d'une manière étendue;
un dispositif optique qui dépend de la longueur d'onde pour produire deux signaux optiques à partir d'une lumière échantillonnée provenant dudit laser (10), lesquels deux signaux optiques dépendent de la longueur d'onde et sont différenciés l'un de l'autre par une dépendance différente du point de vue de la longueur d'onde;
des premier et second détecteurs (49a, 49b; 92a, 92b; 100a, 100b) pour détecter lesdits deux signaux optiques de manière à produire deux signaux de détection électrique correspondants (I1(λ), I2(λ)); et
un processeur couplé auxdits premier et second détecteurs (49a, 49b; 92a, 92b; 100a, 100b) pour produire un signal de commande à partir desdits deux signaux de détection électriques correspondants, à l'aide desquels ledit laser accordable est accordé;
dans lequel le dispositif intégré monolithique à semiconducteurs est intégré sur une seule plaquette semiconductrice monolithique de telle sorte que le laser accordable à semiconducteurs (10), le dispositif optique qui dépend de la longueur d'onde et les premier et second détecteurs (49a, 49b; 92a, 92b; 100a, 100b) sont intégrés de façon monolithique et fabriqués de façon monolithique conjointement à partir de matériaux, d'une structure et d'un procédé de fabrication communs, et de telle sorte que le dispositif optique, qui dépend de la longueur d'onde, génère deux signaux optiques sous la forme de deux signaux optiques obtenus sans guides d'onde et qui dépendent de la longueur d'onde à l'aide de:
a. un diviseur (22) indépendant de la longueur d'onde pour diviser la lumière échantillonnée provenant du laser (10) entre les deux détecteurs (49a, 49b), dont l'un est pourvu d'un filtre d'émission intégré (50) qui dépend de la longueur d'onde et réalisé avec un matériau, une structure et un procédé de fabrication communs; ou
b. un diviseur (22) indépendant de la longueur d'onde pour diviser la lumière échantillonnée provenant du laser (10) entre les deux détecteurs (92a, 92b; 100a, 100b), dont l'un est combiné à un filtre réfléchissant intégré (74) qui dépend de la longueur d'onde et est fabriqué avec les matériaux, la structure et le procédé de fabrication communs; ou
c. les deux détecteurs (49a, 49b) sont alignés entre eux et avec le laser (10), et l'un des détecteurs (49b) dépend de la longueur d'onde en raison d'une absorption plus élevée dans la bande interdite dans le détecteur et est de préférence précédé par un atténuateur (102) et par un filtre (104).
